# EUROPEAN PATENT APPLICATION

(11) **EP 4 840 686 A1**
(43) Date of publication of application: **18.11.2026**
(21) Application number: 26160488.8
(22) Date of filing: 24.02.2026
(51) Int. Cl.: B60L 58/16, G01R 31/374, G01R 31/392, H01M 10/48

(54) **SOH ESTIMATION DEVICE AND SOH ESTIMATION METHOD**

(30) Priority: 12.05.2025 JP 2025079861
(71) Applicant: Toyota Jidosha Kabushiki Kaisha, Toyota-shi, Aichi-ken 471-8571 (JP)
(72) Inventor: OGATA, Yuki, Toyota-shi, 471-8571 (JP)
(74) Representative: D Young & Co LLP

(57) **Abstract**

The present disclosure relates to an SOH estimation device and an SOH estimation method. A processor of a control unit acquires discharged-amount information and temperature information that are related to expansion of an energy storage cell, and outputs a state of health (SOH) of the energy storage cell based on the discharged-amount information and the temperature information.

## Description

### BACKGROUND OF THE INVENTION

### 1. Field of the Invention

The present disclosure relates to SOH estimation devices and SOH estimation methods.

### 2. Description of Related Art

Japanese Unexamined Patent Application Publication No. 2023-127938 (JP 2023-127938 A) describes an SOH estimation method that calculates the state of health (SOH) of a battery from an amount of change in the state of charge (SOC) of the battery and an integrated current amount during that period.

### SUMMARY OF THE INVENTION

When an SOH is calculated based on an amount of change in SOC and an integrated current amount, as in JP 2023-127938 A, the SOH estimation accuracy may decrease due to error factors such as estimation error of an open-circuit voltage (OCV). In other words, estimation of the SOH of a battery (energy storage cell) may become inaccurate.

The present disclosure has been made to address the above issue, and an object thereof is to provide an SOH estimation device and an SOH estimation method capable of suppressing inaccurate estimation of the SOH of an energy storage cell.

An SOH estimation device according to a first aspect of the present disclosure is an SOH estimation device configured to estimate an SOH of an energy storage cell. The SOH estimation device includes: an acquisition unit configured to acquire expansion information related to expansion of the energy storage cell; and a processing unit configured to output an SOH of the energy storage cell based on the expansion information. The expansion information related to expansion of the energy storage cell includes both indirect values from which expansion of the energy storage cell can be calculated (values used for calculating expansion) and values that directly indicate expansion of the energy storage cell.

As described above, in the SOH estimation device according to the first aspect of the present disclosure, the SOH is output based on the expansion information related to expansion of the energy storage cell. Accordingly, the SOH can be output based on the expansion information without using a method in which an SOH is estimated based on an amount of change in SOC and an integrated current amount. Therefore, compared with a case where an SOH is estimated based on an amount of change in SOC, which is a value based on an OCV, an OCV estimation error is less likely to be included in the output SOH value. As a result, inaccurate estimation of the SOH of the energy storage cell can be suppressed.

In the SOH estimation device according to the first aspect, the expansion information may include either or both of energy-amount information and temperature information. The energy-amount information indicates an amount of electric energy transferred to or from the energy storage cell through charging or discharging, and the temperature information indicates a temperature of the energy storage cell during the charging or the discharging. The energy-amount information and the temperature information are information that can be easily acquired based on, for example, a detection value of a sensor. Accordingly, when the expansion information includes either or both of the energy-amount information and the temperature information, an SOH can be easily output based on the expansion information.

In the SOH estimation device according to the first aspect, the expansion information may include either or both of a load applied to the energy storage cell and an expansion amount of the energy storage cell. With this configuration, the SOH can be output using either or both of the load applied to the energy storage cell and the expansion amount of the energy storage cell.

In the SOH estimation device according to the first aspect, the processing unit may be configured to calculate an SOC of the energy storage cell and output the SOH based on the SOC and the expansion information. With this configuration, the SOH can be output based not only on the expansion information but also on the SOC. The expansion amount of the energy storage cell is a value that also depends on the SOC. Accordingly, unlike a case where an SOH is output based solely on the expansion information, the SOH can be corrected using the SOC. As a result, inaccurate SOH estimation can further be suppressed.

An SOH estimation method according to a second aspect of the present disclosure is an SOH estimation method executed by an SOH estimation device configured to estimate an SOH of an energy storage cell. The SOH estimation method includes: acquiring expansion information related to expansion of the energy storage cell; and outputting an SOH of the energy storage cell based on the expansion information.

In the SOH estimation method according to the second aspect of the present disclosure, as described above, the SOH is output based on the expansion information related to expansion of the energy storage cell. Accordingly, it is possible to provide an SOH estimation method capable of suppressing inaccurate estimation of the SOH of an energy storage cell.

According to the SOH estimation device and the SOH estimation method of the present disclosure, inaccurate estimation of the SOH of an energy storage cell can be suppressed.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG. 1 is a schematic diagram showing the configuration of a vehicle equipped with a battery pack including a control unit according to a first embodiment;
FIG. 2 is a graph showing the relationship between the expansion amount of an energy storage cell and the SOH of the energy storage cell;
FIG. 3 is a first flowchart showing control performed by the control unit according to the first embodiment;
FIG. 4 is a second flowchart showing control performed by the control unit according to the first embodiment;
FIG. 5 is a schematic diagram showing the configuration of a battery pack including a control unit according to a second embodiment; and
FIG. 6 is a flowchart showing control performed by the control unit according to the second embodiment.

### DETAILED DESCRIPTION OF EMBODIMENTS

Embodiments of the present disclosure will be described in detail below with reference to the drawings. The same or corresponding portions are denoted by the same signs throughout the drawings, and description thereof will not be repeated.

### First Embodiment

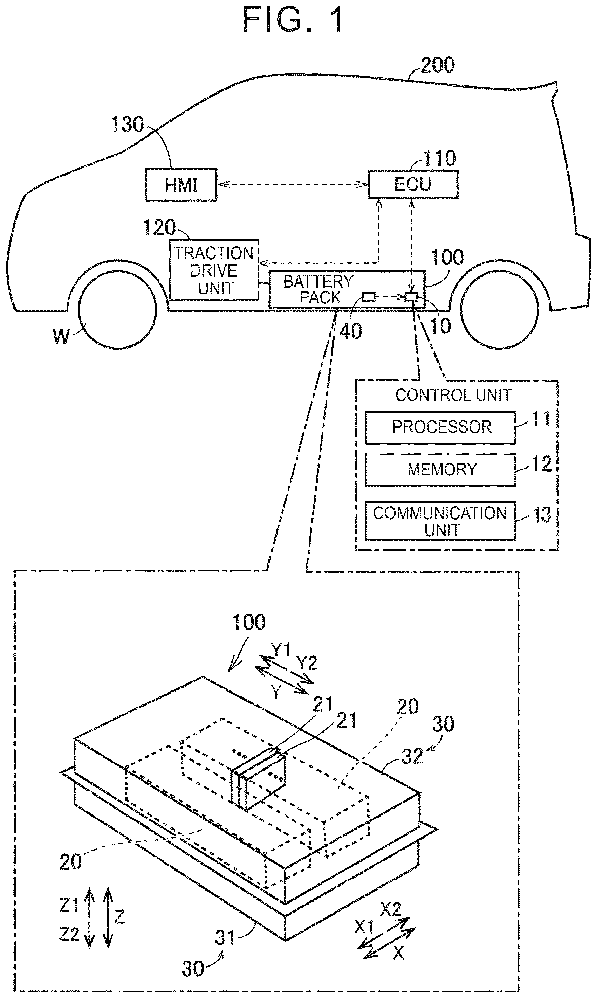

FIG. 1 is a schematic diagram showing the overall configuration of a vehicle 200 equipped with a battery pack 100 including a control unit 10 according to a first embodiment. The X-direction, Y-direction, and Z-direction shown in FIG. 1 are directions perpendicular to each other. For example, the X-direction and the Y-direction may correspond to the width direction and front-rear direction of the vehicle 200, respectively, when the battery pack 100 is mounted on the vehicle 200. The X1-direction and the X2-direction may correspond to the directions toward the left side and right side of the vehicle, respectively. The Y1-direction and the Y2-direction may correspond to the directions toward the front side and rear side of the vehicle, respectively. The Z-direction may correspond to the up-down (vertical) direction. The Z1-direction and the Z2-direction may correspond to upward and downward directions, respectively. The control unit 10 is an example of the "SOH estimation device" of the present disclosure.

The battery pack 100 stores electric power for driving the vehicle 200. That is, the vehicle 200 is configured to run on electric power stored in the battery pack 100. The vehicle 200 may be, for example, a battery electric vehicle (BEV) without an engine (internal combustion engine). The vehicle 200 may instead be a hybrid electric vehicle (HEV) or a plug-in hybrid electric vehicle (PHEV) that includes an engine. The application of the battery pack 100 is not limited to vehicle applications.

The vehicle 200 includes a control device (electronic control unit (ECU)) 110. The ECU 110 is configured to perform charge control and discharge control of the battery pack 100. The battery pack 100 is charged by regenerative power from a traction drive unit 120 described later, or is charged (external charging) by power supplied from charging equipment external to the vehicle 200.

The vehicle 200 further includes the traction drive unit 120, a human machine interface (HMI) device 130, and drive wheels W. The traction drive unit 120 includes a power control unit (PCU) and a motor generator (MG), which are not shown. The traction drive unit 120 drives the MG using electric power stored in the battery pack 100 to cause the vehicle 200 to travel. The MG supplies electric power generated by regenerative power generation to the battery pack 100.

The HMI device 130 includes an input device and a display device. The HMI device 130 may include a touch panel display.

The ECU 110 communicates with the battery pack 100 (control unit 10), the traction drive unit 120, the HMI device 130, and the like by controller area network (CAN) communication or the like.

The battery pack 100 includes a plurality of (two in FIG. 1) energy storage modules 20 and a battery case 30. Each of the energy storage modules 20 is housed in the battery case 30. The energy storage modules 20 are arranged side by side in the X-direction. The battery case 30 is made of metal (for example, aluminum).

The battery case 30 includes a lower case 31 and an upper case 32. The battery case 30 has a sealed structure. The two energy storage modules 20 are housed in a sealed space formed by combining the lower case 31 and the upper case 32. The battery pack 100 is mounted on the floor of the vehicle 200. The battery pack 100 may be mounted inside the cabin of the vehicle 200 or may be mounted outside the cabin of the vehicle 200.

Each energy storage module 20 is a battery assembly in which a plurality of energy storage cells 21 is connected. In each energy storage module 20, the energy storage cells 21 are stacked in the Y-direction. In FIG. 1, only two of the energy storage cells 21 in the battery assembly are shown for simplicity. The energy storage cells 21 are prismatic cells.

The battery pack 100 includes a temperature sensor 40. The temperature sensor 40 detects the temperature of the energy storage module 20 (energy storage cells 21). The temperature sensor 40 may be provided in each energy storage module 20. Information on a detection value of the temperature sensor 40 is transmitted to a communication unit 13 described later.

The control unit 10 includes a processor 11, a memory 12, and the communication unit 13. The control unit 10 may be, for example, a monitoring integrated circuit (IC) that monitors a state such as the voltage of the energy storage module 20 (energy storage cells 21). The processor 11 is an example of the "processing unit" and the "acquisition unit" of the present disclosure.

The memory 12 is configured to retain stored information. The memory 12 stores programs and information to be used by the programs (for example, maps, mathematical expressions, and various parameters). The processor 11 executes the programs stored in the memory 12, enabling the control unit 10 to perform various processes.

The processor 11 may be, for example, a central processing unit (CPU) or a micro-processing unit (MPU). The processor 11 implements various processes by reading a system program and a control program, loading them into the memory 12, and executing them. In the present specification, the term "processor" is not limited to a processor in the narrow sense that executes processing based on a stored program, but may also include hardwired circuits such as application-specific integrated circuits (ASICs) and field-programmable gate arrays (FPGAs). Therefore, the term "processor" may be interpreted as "processing circuitry" in which processing is defined in advance by computer-readable code and/or a hardwired circuit.

The control unit 10 stores, in the memory 12, discharged-amount information indicating an amount of electric energy discharged from the energy storage cells 21 (energy storage module 20) through discharging. The control unit 10 may calculate the discharged amount of the energy storage cell 21 based on detection values from a current sensor that detects current flowing through the energy storage cell 21 and a voltage sensor that detects the voltage of the energy storage cell 21 (neither of them is shown). The discharged-amount information may include information on an integrated discharged amount from an initial state of the energy storage cell 21. The discharged-amount information is an example of the "expansion information" and the "energy-amount information" in the present disclosure.

The control unit 10 also stores, in the memory 12, temperature information indicating a detection value of the temperature sensor 40 when the above discharging is performed (that is, the temperature of the energy storage cells 21). The temperature information may include information on the average value of detection values of the temperature sensor 40 during discharging. Specifically, when the discharge process is performed a plurality of times, the temperature information may include information on the average value of the temperatures in the discharge processes. The temperature information is an example of the "expansion information" in the present disclosure.

Each of the discharged amount of the energy storage cell 21 and the temperature during discharging correlates with expansion (expansion amount) of the energy storage cell 21. The memory 12 stores a plurality of expansion coefficients predetermined for respective temperatures. Each expansion coefficient indicates an amount of change in the expansion amount with respect to an amount of change in the discharged amount. The control unit 10 calculates the expansion amount by multiplying the discharged amount by the expansion coefficient corresponding to the temperature of the energy storage cell 21. The expansion amount is an example of a "value based on expansion" in the present disclosure.

The discharged amount of the energy storage cell 21 refers to a total amount of electric energy discharged from the energy storage cell 21 from the time of manufacture to the present. When the discharge process has been performed a plurality of times from the time of manufacture to the present, the sum of products of the expansion coefficient corresponding to the temperature (average temperature) of the energy storage cell 21 in each discharge process and the discharged amount in each discharge process is the expansion amount of the energy storage cell 21.

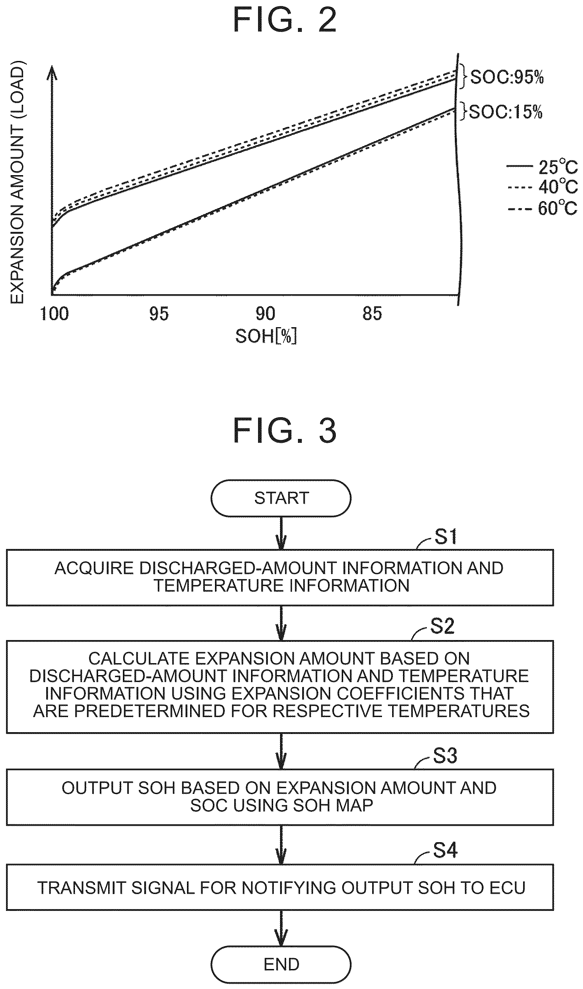

FIG. 2 is a graph showing the relationship between the expansion amount of the energy storage cell 21 and the state of health (SOH) of the energy storage cell 21 obtained through experiments (simulations).

As shown in FIG. 2, as the SOH decreases, the expansion amount of the energy storage cell 21 increases. Specifically, the expansion amount of the energy storage cell 21 increases linearly with a decrease in SOH. Since a graph at an SOC of 15% and a graph at an SOC of 95% are separated from each other, it can be understood that the expansion amount of the energy storage cell 21 depends on the SOC of the energy storage cell 21. Since the graphs at each SOC hardly diverge even when the temperature of the energy storage cell 21 changes, it can be understood that the expansion amount of the energy storage cell 21 hardly depends on the temperature of the energy storage cell 21. As described above, while the expansion amount changes significantly as SOC changes, the expansion amount hardly changes even when the temperature of the energy storage cell 21 changes.

The memory 12 (FIG. 1) stores a map that is predetermined based on the relationship shown in FIG. 2 (hereinafter referred to as an "SOH map"). The SOH map indicates the relationship between the expansion amount of the energy storage cell 21 and SOC of the energy storage cell 21, and the SOH of the energy storage cell 21. That is, in the SOH map, each combination of the expansion amount and the SOC corresponds one-to-one to the SOH. The SOC in the SOH map may be defined with a step width of, for example, 5%.

Conventional systems may use an SOH estimation method in which an SOH is calculated from an amount of change in SOC of a battery and an integrated current amount during that period. In such a case, the SOH estimation accuracy decrease due to error factors such as an OCV estimation error. In other words, estimation of the SOH of energy storage cells of the battery becomes inaccurate.

In the first embodiment, the processor 11 outputs the SOH of the energy storage cell 21 based on the discharged-amount information and the temperature information that are related to expansion of the energy storage cell 21. Specifically, the processor 11 outputs the SOH of the energy storage cell 21 based on (i) the expansion amount of the energy storage cell 21 calculated from the discharged amount of the energy storage cell 21 derived from the discharged-amount information and the temperature of the energy storage cell 21 derived from the temperature information, and (ii) the SOH map. That is, the processor 11 outputs the SOH of the energy storage cell 21 using, as input values, the calculated expansion amount of the energy storage cell 21 and the SOH map stored in the memory 12. As a result, the SOH of the energy storage cell 21 can be calculated without using an SOH estimation method in which an SOH is calculated from an amount of change in SOC of a battery and an integrated current amount during that period.

### SOH Estimation Method

Next, an SOH estimation method executed by the control unit 10 (processor 11) will be described with reference to the control flow shown in FIG. 3. The control flow shown in FIG. 3 may be executed at predetermined intervals (for example, once per month) or for each predetermined process (for example, each discharge process).

In step S1, the control unit 10 (processor 11) acquires discharged-amount information and temperature information of the energy storage cell 21. Specifically, the processor 11 acquires the discharged-amount information and the temperature information by reading information stored in the memory 12. Alternatively, the control unit 10 may receive the discharged-amount information and the temperature information from another unit (for example, the ECU 110).

In step S2, the control unit 10 calculates the expansion amount of the energy storage cell 21 based on the discharged-amount information and the temperature information using expansion coefficients that are predetermined for respective temperatures, as described above.

In step S3, the control unit 10 outputs (calculates) the SOH of the energy storage cell 21 based on the expansion amount calculated in step S2 and the SOC (current SOC) of the energy storage cell 21, using the SOH map. The SOC may be calculated by a known method.

In step S4, the control unit 10 transmits, to the ECU 110, a signal for notifying the SOH output in step S3. In response to the signal, the ECU 110 may transmit a predetermined command signal to the HMI device 130 or the like. The command signal may include, for example, a signal instructing issuance of a warning and a signal instructing notification of the SOH to a user. The process then ends.

### Expansion Amount Calculation Control

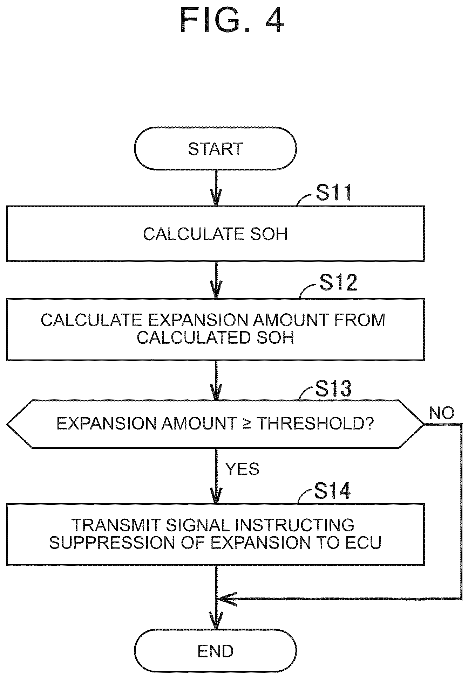

Next, control for calculating the expansion amount of the energy storage cell 21 will be described with reference to the control flow shown in FIG. 4. The control flow shown in FIG. 4 may be executed at predetermined intervals (for example, once per month).

In step S11, the control unit 10 calculates the SOH of the energy storage cell 21. For example, the control unit 10 may calculate the SOH from an amount of change in SOC during charging or discharging and an integrated current amount during that period. The method for calculating an SOH is not limited to this example, as long as it differs from the method used in step S3 of FIG. 3.

In step S12, the control unit 10 calculates the expansion amount of the energy storage cell 21 from the SOH calculated in step S11. For example, the control unit 10 may calculate the expansion amount of the energy storage cell 21 based on the SOH calculated in step S11 and the SOC (current SOC) of the energy storage cell 21, using the SOH map.

In step S13, the control unit 10 determines whether the expansion amount calculated in step S12 is greater than or equal to a threshold. When the expansion amount is greater than or equal to the threshold (Yes in step S13), the process proceeds to step S14. When the expansion amount is less than the threshold (No in step S13), the process ends.

In step S14, the control unit 10 transmits, to the ECU 110, a command signal instructing suppression of expansion of the energy storage cell 21. For example, when the ECU 110 receives the command signal, the ECU 110 may perform control to reduce an upper limit of the SOC of the energy storage cell 21. Alternatively, the control unit 10 may perform processing to suppress expansion of the energy storage cell 21 without transmitting the command signal to the ECU 110. The process then ends.

The control unit 10 may also compare the SOH calculated in step S11 of FIG. 4 with the SOH output in step S3 of FIG. 3. For example, after step S3, the control unit 10 may determine whether the difference between the SOH output in step S3 and the SOH calculated in step S11 is greater than or equal to a threshold. In this case, the control unit 10 may proceed to step S4 when the difference is less than the threshold, and may end the process when the difference is greater than or equal to the threshold.

As described above, in the first embodiment, the control unit 10 outputs the SOH of the energy storage cell 21 based on discharged-amount information and temperature information related to expansion of the energy storage cell 21. When an SOH is calculated based on an amount of change in SOC and an integrated current amount, the magnitude of an SOC error caused by an OCV estimation error directly affects the calculated SOH value. In contrast, in the SOH estimation method of the present embodiment, the SOH is output based not only on SOC but also on the expansion amount of the energy storage cell 21. This reduces the influence of the magnitude of an SOC error on the output SOH value. Accordingly, compared with a case where an SOH is calculated based on an amount of change in SOC and an integrated current amount, error factors such as an OCV estimation error are less likely to be included in the output SOH value. As a result, inaccurate estimation of the SOH of the energy storage cell 21 can be suppressed.

In addition, compared with a method in which an SOH is estimated from a charged amount (or discharged amount) obtained when the battery pack 100 is fully charged (or discharged until the SOC becomes 0%), the timing for acquiring information to be used for estimating an SOH (discharged-amount information and temperature information) is less constrained. As a result, constraints on the timing of SOH estimation can be reduced. Furthermore, since there is no need to wait for polarization of the energy storage cell 21 to dissipate after charging or discharging, SOH estimation can be performed easily and quickly.

### Second Embodiment

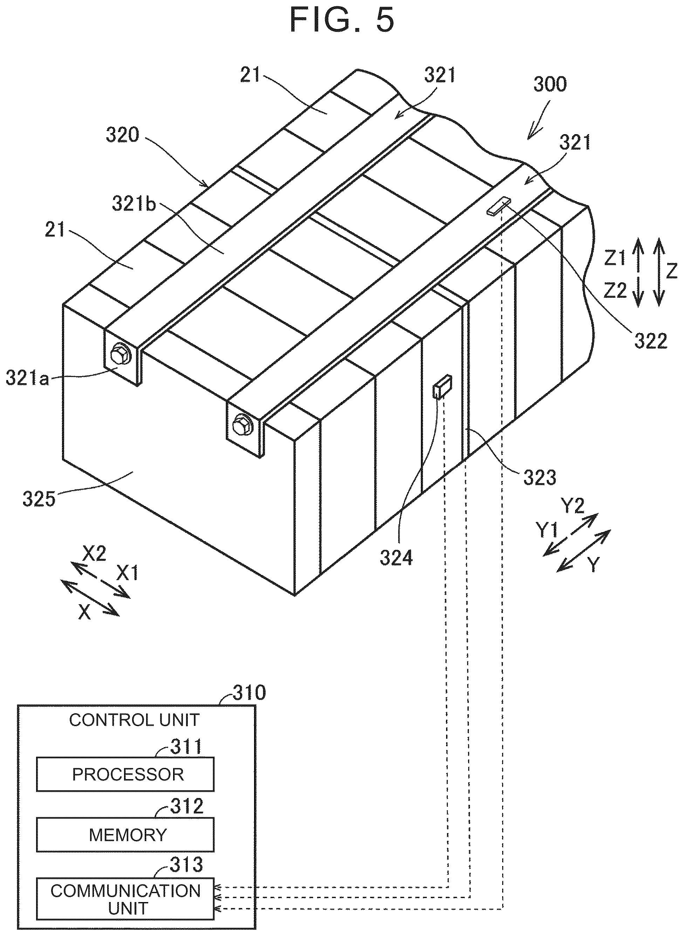

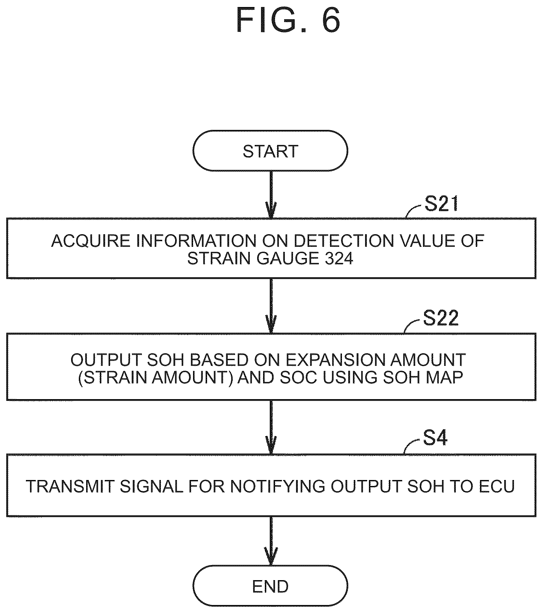

Next, a second embodiment of the present disclosure will be described with reference to FIGS. 5 and 6. Unlike the first embodiment in which the expansion amount of the energy storage cell 21 is calculated from discharged-amount information and temperature information, the expansion amount of the energy storage cell 21 is directly detected in the second embodiment. The same components as those of the first embodiment are denoted by the same signs as those of the first embodiment, and description thereof will not be repeated.

FIG. 5 is a schematic diagram showing the configuration of a battery pack 300 including a control unit 310 according to the second embodiment.

The battery pack 300 includes a restraint band 321, a strain gauge 322, a pressure sensor 323, a strain gauge 324, and a pair of end plates 325. In the second embodiment, the strain gauge 322 and the pressure sensor 323 may be omitted.

The end plates 325 are made of a metal material. For example, each end plate 325 is formed of a steel plate. The end plates 325 sandwich the energy storage cells 21 in the Y-direction. One of the end plates 325 is arranged adjacent, in the Y-direction, to the energy storage cell 21 located furthest on the Y1-side among the energy storage cells 21. The other end plate 325 (not shown) is arranged adjacent, in the Y-direction, to the energy storage cell 21 located furthest on the Y2-side among the energy storage cells 21.

The restraint band 321 is made of a metal material. The restraint band 321 restrains the end plates 325 and the energy storage cells 21 from both sides in the Y-direction. The end plates 325 and the energy storage cells 21 are restrained by two restraint bands 321. The two restraint bands 321 are arranged side by side in the X-direction.

Each restraint band 321 is shaped so as to extend from the end plate 325 on the Y1-side to the end plate 325 on the Y2-side. Each restraint band 321 includes a pair of end portions 321a and a connecting portion 321b that connects the end portions 321a. Of the end portions 321a, the end portion 321a on the Y1-side is fixed (fastened) to the end plate 325 on the Y1-side. Of the end portions 321a, the end portion 321a on the Y2-side (not shown) is fixed (fastened) to the end plate 325 on the Y2-side. The connecting portion 321b extends in the Y-direction so as to cross over the upper surfaces of the energy storage cells 21.

The strain gauge 322 is provided on the restraint band 321. The strain gauge 322 is disposed on the connecting portion 321b of the restraint band 321. The strain gauge 322 detects an amount of change in the length of the connecting portion 321b in the Y-direction (that is, the expansion amount of an energy storage module 320 in the Y-direction). In FIG. 5, the strain gauge 322 is provided on one of the restraint bands 321. However, the strain gauge 322 may be provided on each of the restraint bands 321. The strain gauge 322 may be provided on the end portion 321a. A plurality of strain gauges 322 may be provided on the restraint band 321.

The pressure sensor 323 is disposed between adjacent energy storage cells 21 in the Y-direction. The pressure sensor 323 is in contact with the energy storage cells 21 on both sides in the Y-direction. Although one pressure sensor 323 is provided in FIG. 5, a plurality of pressure sensors 323 may be provided at different positions.

The strain gauge 324 is provided on the energy storage cell 21. Specifically, the strain gauge 324 is disposed on the outer surface of a cell case (reference sign omitted) that houses an electrode assembly (not shown) of the energy storage cell 21. The strain gauge 324 detects an amount of change in the width of the outer surface in the Y-direction (that is, the expansion amount of the energy storage cell 21 in the Y-direction). In FIG. 5, the strain gauge 324 is disposed on the outer surface on the X1-side of the energy storage cell 21 (cell case). However, the position at which the strain gauge 324 is provided on the energy storage cell 21 is not limited to this example. In FIG. 5, the strain gauge 324 is provided on one energy storage cell 21. However, the strain gauge 324 may be provided on each of the energy storage cells 21. The detection value of the strain gauge 324 is an example of the "expansion amount" and the "expansion information" according to the present disclosure.

Each of the strain gauge 322, the pressure sensor 323, and the strain gauge 324 transmits its detection value to a communication unit 313 (described later) of the control unit 310.

The control unit 310 includes a processor 311, a memory 312, and the communication unit 313. The control unit 310 may be, for example, a monitoring IC that monitors a state such as the voltage of the energy storage module 320 (energy storage cells 21). The processor 311 and the communication unit 313 are examples of the "processing unit" and the "acquisition unit" of the present disclosure, respectively.

The memory 312 is configured to retain stored information. The memory 312 stores programs and information to be used by the programs (for example, maps, mathematical expressions, and various parameters). The processor 311 executes the programs stored in the memory 312, enabling the control unit 310 to perform various processes.

### SOH Estimation Method

Next, an SOH estimation method executed by the control unit 310 (processor 311) will be described with reference to the control flow shown in FIG. 6. The control flow shown in FIG. 6 may be executed at predetermined intervals (for example, once per month) or for each predetermined process (for example, each discharge process). The same steps as those in the control flow of the first embodiment are denoted by the same signs as those in the first embodiment, and description thereof will not be repeated.

In step S21, the control unit 310 acquires information on a detection value of the strain gauge 324. Specifically, the processor 311 acquires the information on the detection value of the strain gauge 324 via the communication unit 313. The process then proceeds to step S22.

In step S22, the control unit 310 outputs the SOH of the energy storage cell 21 using the SOH map, in the same manner as in the first embodiment. Specifically, the control unit 310 outputs the SOH of the energy storage cell 21 based on the expansion amount of the energy storage cell 21 and the SOC (current SOC) of the energy storage cell 21, using the SOH map. The detection value of the strain gauge 324 may be used as the expansion amount of the energy storage cell 21. The process then proceeds to step S4.

Other configurations are the same as those of the first embodiment.

### Modifications

The first and second embodiments illustrate examples in which the SOH of the energy storage cell 21 is output based on the expansion amount of the energy storage cell 21. However, the present disclosure is not limited to this. The SOH of the energy storage cell 21 may alternatively be output based on a load applied to the energy storage cell 21.

Specifically, as a modification of the first embodiment, a load applied to the energy storage cell 21 may be calculated based on a load coefficient instead of an expansion coefficient. The load coefficient represents an amount of change in the load applied to the energy storage cell 21 with respect to an amount of change in discharged amount. A predetermined value may be stored in a memory or the like as the load coefficient. The load applied to the energy storage cell 21 is a value correlated with (for example, proportional to) the expansion amount of the energy storage cell 21. The load applied to the energy storage cell 21 may be calculated by multiplying the discharged amount by a load coefficient corresponding to the temperature of the energy storage cell 21 during discharge. As a modification of the second embodiment, the load applied to the energy storage cell 21 may be calculated based on a detection value of the pressure sensor 323. In these modifications, the SOH map may indicate the relationship between the load applied to the energy storage cell 21 and SOC of the energy storage cell 21, and the SOH of the energy storage cell 21.

The SOH of the energy storage cell 21 may be output (calculated) based on both the expansion amount of the energy storage cell 21 and the load applied to the energy storage cell 21.

The second embodiment illustrates an example in which the SOH is output based on a detection value of the strain gauge 324. However, the present disclosure is not limited to this. The SOH may be output based on a detection value of the strain gauge 322. In this case, a value obtained by dividing the detection value of the strain gauge 322 by a predetermined value (for example, the number of energy storage cells 21) may be used as the expansion amount of the energy storage cell 21.

The first embodiment illustrates an example in which the expansion amount of the energy storage cell 21 is calculated using discharged-amount information. However, the present disclosure is not limited to this. The expansion amount of the energy storage cell 21 may be calculated using charged-amount information indicating an amount of charge supplied to the energy storage cell 21. Alternatively, the expansion amount of the energy storage cell 21 may be calculated using both charged-amount information and discharged-amount information.

The first embodiment illustrates an example in which the expansion amount of the energy storage cell 21 is calculated using discharged-amount information and temperature information. However, the present disclosure is not limited to this. The expansion amount of the energy storage cell 21 may be calculated using either discharged-amount information or temperature information.

The first and second embodiments illustrate examples in which the SOH of the energy storage cell 21 is output based on the expansion amount and SOC of the energy storage cell 21. However, the present disclosure is not limited to this. The SOH may be output based on the expansion amount of the energy storage cell 21 rather than based on both the expansion amount and SOC of the energy storage cell 21.

The first embodiment illustrates an example in which the expansion coefficient is predetermined for each temperature. However, the present disclosure is not limited to this. The expansion coefficient may be predetermined for each temperature and SOC. That is, the expansion coefficient may be predetermined for each combination of temperature and SOC.

The first embodiment illustrates an example in which the expansion amount of the energy storage cell 21 is calculated using an expansion coefficient. However, the present disclosure is not limited to this. The expansion amount of the energy storage cell 21 may be output using a map indicating the correspondence between the discharged amount and temperature of the energy storage cell 21 and the expansion amount of the energy storage cell 21. Although an example has been illustrated in which the SOH of the energy storage cell 21 is output using an SOH map, the SOH of the energy storage cell 21 may instead be calculated using a predetermined calculation formula.

The first and second embodiments illustrate examples in which a battery assembly is formed by a plurality of energy storage cells 21. However, the present disclosure is not limited to this. A battery assembly may not be formed by a plurality of energy storage cells. That is, a plurality of single cells may be provided independently of each other.

The first and second embodiments illustrate examples in which the energy storage cells are prismatic cells. However, the present disclosure is not limited to this. The energy storage cells may be cylindrical cells or laminate-type cells.

The first and second embodiments illustrate examples in which the control unit (SOH estimation device) is provided in a vehicle (battery pack). However, the present disclosure is not limited to this. The SOH estimation device may be provided separately from a vehicle (battery pack). For example, the SOH estimation device may be provided at a dealer or the like. In this case, SOH estimation may be performed by the SOH estimation device extracting information used for SOH estimation from a vehicle of a user who visits the dealer.

All or part of the embodiments and modifications described above may be combined as appropriate.

The embodiments disclosed herein should be considered to be illustrative in all respects and not restrictive. The scope of the present disclosure is defined by the claims rather than by the foregoing description of the embodiments, and all modifications falling within the meaning and scope equivalent to the claims are intended to be included.

## Claims

1. A state-of-health estimation device configured to estimate a state of health of an energy storage cell, the state-of-health estimation device comprising:
an acquisition unit configured to acquire expansion information related to expansion of the energy storage cell; and
a processing unit configured to output a state of health of the energy storage cell based on the expansion information.

2. The state-of-health estimation device according to claim 1, wherein the expansion information includes either or both of energy-amount information and temperature information, the energy-amount information indicating an amount of electric energy transferred to or from the energy storage cell through charging or discharging, and the temperature information indicating a temperature of the energy storage cell during the charging or the discharging.

3. The state-of-health estimation device according to claim 1 or 2, wherein the expansion information includes either or both of a load applied to the energy storage cell and an expansion amount of the energy storage cell.

4. The state-of-health estimation device according to claim 1 or 2, wherein the processing unit is configured to
calculate a state of charge of the energy storage cell, and
output the state of health based on the state of charge and the expansion information.

5. A state-of-health estimation method executed by a state-of-health estimation device configured to estimate a state of health of an energy storage cell, the state-of-health estimation method comprising:
acquiring expansion information related to expansion of the energy storage cell; and
outputting a state of health of the energy storage cell based on the expansion information.
